# EUROPEAN PATENT SPECIFICATION

(11) **EP 0 561 302 B1**
(45) Date of publication and mention of the grant of the patent: **18.11.1998**
(21) Application number: 93104078.6
(22) Date of filing: 12.03.1993
(51) Int. Cl.: G03F 9/00

(54) **Manufacture of alignment marks for holographic lithography**
Herstellung von Ausrichtmarken für holographische Lithographie
Fabrication de marques d'alignement pour la lithographie holographique

(30) Priority: 16.03.1992 US 852024
(43) Date of publication of application: 22.09.1993
(73) Proprietor: HOLTRONIC TECHNOLOGIES LTD., CH-2074 Marin (CH)
(72) Inventor: Omar, Basil Arthur, c/o Holtronic Technologies Ltd, CH-2074 Marin (CH)
(74) Representative: Riederer, Conrad A., Dr.

(56) References cited:
- US-A- 4 857 425
- PATENT ABSTRACTS OF JAPAN vol. 8, no. 163 (P-290)27 July 1984 & JP-A-59 060 462 ( FUJITSU KK ) 6 April 1984
- PATENT ABSTRACTS OF JAPAN vol. 14, no. 467 (E-989)11 October 1990 & JP-A-02 192 114 ( CANON INC ) 27 July 1990

## Description

The present invention relates to the field of microlithography as employed for the manufacture of microelectronics and other types of device comprising high resolution features. In particular it relates to layer-to-layer registration in a microlithographic system based on total internal reflection holography.

Microdevices such as integrated circuits are commonly multi-level structures, each layer containing a pattern of high resolution features in a particular material. In order for the microdevice to perform correctly it is essential that the features in the different layers be very accurately registered, or aligned, with respect to each other. To quantify this, the accuracy of alignment between layers typically needs to be to one quarter of the dimension of the smallest features; so, if the smallest features are of dimension 2µm, the layers must be aligned with an accuracy of 0.5µm.
Conventional lithographic systems for manufacturing microdevices, such as contact printers, proximity printers and optical steppers, function by optically transferring a pattern of features defined in a mask into a layer of photosensitive material on a substrate surface. Post-lithographic processing then transfers the pattern from the photosensitive layer into a material with the appropriate electrical, electro-optic, or whatever, properties. This sequence is repeated a number of times with a variety post-lithographic treatments to construct the complete structure of the microdevice.

The alignment systems in conventional lithographic equipment rely on reference marks included in the mask alongside the circuit pattern and corresponding marks printed on the substrate surface alongside the circuit features. The alignment system measures the relative positions of the marks on the mask with respect to the marks on the wafer by, for instance, laser-beam scanning, where the marks are scanned and the scattered light detected, or by imaging the marks, where the image either falls onto a detector array or is viewed as a virtual image through a microscope. Following measurement the wafer or mask is appropriately translated and/or rotated to its aligned position, whereupon printing takes place.

These methods however require that the alignment marks in the mask and on the wafer are clearly defined features and furthermore that the marks are accurately registered with respect to the circuit patterns on the respective surfaces. With respect to the latter, by fabricating the marks in the mask using the same process as for the circuit pattern, they are necessarily accurately registered with respect to the mask circuit pattern. Similarly, by including the wafer marks in a mask alongside the circuit features and transferring the marks and circuit pattern to the wafer using the same process, the marks on the wafer are accurately registered with respect to the wafer circuit pattern. Concerning the definition and visibility of the mask marks, since photomasks are in the form of spaces in an opaque layer, or its negative, the alignment marks included therein are readily detectable by an alignment system and so afford good measurement accuracy.

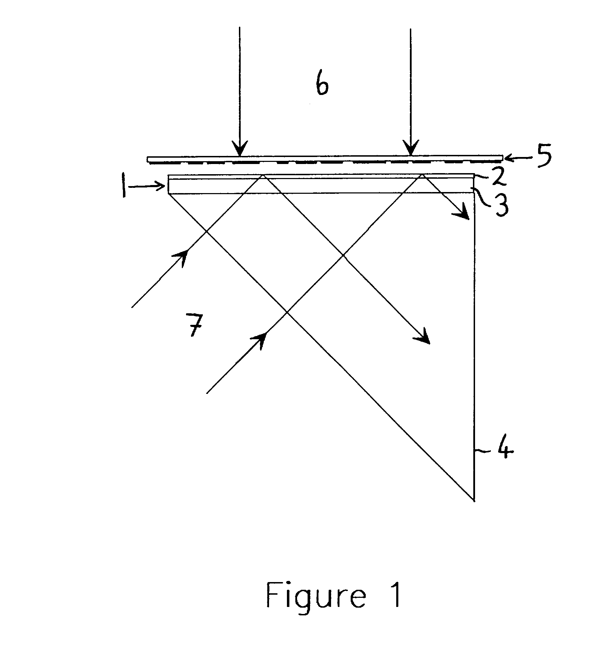

A microlithographic technique that is attracting increasing interest is based on total internal reflection holography (see US 4857425). Total internal reflection (TIR) holography has been demonstrated to be powerful technique for sub-micron lithography (see References **1-2**) . The main principles of TIR hologram recording are illustrated in Figure **1**. A holographic plate **1** comprising a holographic recording layer **2** on a substrate **3** is put in optical contact with a surface of a large prism **4**. An object in the form of a mask transparency **5** lies in proximity to the recording layer **2**. Two mutually coherent beams illuminate the system. One, the object beam **6**, passes through the mask transparency **5** to the recording layer **2** and the other, the reference beam **7**, is directed through another face of the prism **4** so that it is totally internally reflected from the surface of the holographic layer **2**. The optical interference of the two beams **6 and** **7** is recorded by the photosensitive material in the layer **2** to produce a TIR hologram. After fixing, the hologram substrate **3** is placed back in optical contact with the prism **4** but rotated through 180°. Illumination by the reference beam **7**, which is now the conjugate beam of the reference beam during recording, generates an accurate reproduction of the pattern contained in the original mask **5**, and this image can be used to perform lithography. With the prism and hologram in the configuration depicted in Fig.**1**, an imaging or scanning alignment system in a TIR holographic lithographic system would preferably interrogate the hologram and wafer surfaces via the vertical face of the prism.

For TIR holographic lithography, as for conventional lithography, the formation of well-defined and accurately registered alignment marks on the wafer surface is straightforward : these marks can be included in a photomask alongside the circuit pattern, all of which is then recorded and printed using the TIR holographic process. The formation of well-defined and detectable alignment marks in the hologram however is another matter.

Whereas the features in a photomask are spaces in an opaque layer, or its negative, a TIR hologram is a complex modulation of refractive index including a very high spatial frequency component (~3000 lines/mm). Therefore any alignment marks present in a photomask will be transformed by the TIR hologram recording process into structures that are, to all intents and purposes, invisible to an imaging or scanning alignment system.

JP-A-59 060 462 discloses a method for forming a high reliability hologram disk device in which marks for aligning the center position of a revolving shaft with respect to a specified position of a hologram pattern are formed in a photosensitive layer. The alignment marks are formed by illuminating marks in two separate photomasks and imaging the projected light through lenses onto the photosensitive layer. After formation of the alignment marks, a hologram is formed by illuminating a pattern in a further separate mask with two laser beams.

JP-A-02 192 114 discloses a method for aligning a reticle and a wafer in highly precise manner by means of two holograms which are formed on the reticle. In order to regenerate images of the holograms in the mask a lens is required between the mask and the wafer. The light which is projected from the wafer at an angle α_{w} is detected for aligning the reticle and the wafer in a highly precise manner.

It is therefore an object of the present invention to provide a method for forming alignment marks in a holographic recording layer such that the marks can be accurately located with respect to an image to be reconstructed from a TIR hologram recorded in the layer and such that the marks have sufficient definition and contrast that they can be readily detected by an imaging or scanning alignment system.

According to a first aspect of the invention there is provided a method for forming alignment marks detectable by an alignment system, and a total internal reflection hologram in a holographic recording layer for a lithographic process, which method includes:
a) providing alignment marks (10) in a mask (11), said mask defining also the pattern (12) to be reconstructed from said total internal reflection hologram;
b) providing a total internal reflection hologram recording system;
c) locating said holographic recording layer (14) and said mask (11) in the total internal reflection hologram recording system;
d) forming a total internal reflection hologram of the pattern in the mask by illuminating the mask with a first object beam (18) and the holographic recording layer (14) with a reference beam (19); and
e) transferring the alignment marks (10) in the mask (11) to the holographic recording layer (14) by illuminating the mask (11) with the first object beam (18) or with a second object beam derived from a second light source;
wherein the features of the alignment marks (10) in the mask (11) are of sufficient size with regard to the wavelength of the illuminating object beam (18) and the separation of the mask (11) and recording layer (14) that the alignment marks (10) formed in the holographic recording layer (14) are well-defined regions of constant but different refractive index and/or substantially constant but different layer thickness of exposed and unexposed regions so that light reflected and scattered from either side of a boundary will combine to produce a detectable feature.

By this method the alignment marks are recorded in the holographic layer as regions of substantially constant but different refractive index and/or layer thickness. Whereas a change in refractive index and/or a change in layer thickness are not by themselves visible to an imaging or scanning alignment system, a boundary between exposed and unexposed regions can be. If the boundaries between the regions possessing different refractive indices and/or thicknesses are sufficiently sharp and the illumination of the marks by the alignment system has sufficient spatial coherence across the boundaries, then the light reflected and scattered from either side of a boundary will combine to produce a detectable feature. The sharpness of the boundaries formed in the recording layer, which also determines the accuracy of the alignment measurement, depends on the sharpness of the 'mark shadow' in the object beam transmitted by the mask. In order that diffraction does not unacceptably degrade edge definition, the features of the mark must be of sufficient size with regard to the wavelength of the illuminating object beam and to the separation of mask and recording layer.

So that the alignment marks recorded in the holographic layer are accurately registered with respect to the pattern in the mask, and therefore with respect to the image of the pattern to be reconstructed from the TIR hologram, it is necessary that the object beam transferring the marks illuminates the mask at an accurately determined angle, preferably normal incidence; otherwise there will be an arbitrary lateral displacement of the recorded alignment mark with respect to the mask pattern. If the beam performing mark transfer is at an arbitrary angle, it will produce an error in the alignment measurement, although this, in principle, could be compensated for by the lithographic system.

The present invention will now be described in greater detail by way of example with reference to the following drawings, wherein :
- Figure **1**,: already described, illustrates the main principles of total internal reflection holography.
- Figure **2**: illustrates an alignment mark.
- Figure **3**: shows the locations of alignment marks on a mask.
- Figure **4**: schematically shows an apparatus for forming alignment marks and a TIR hologram in a holographic recording layer.

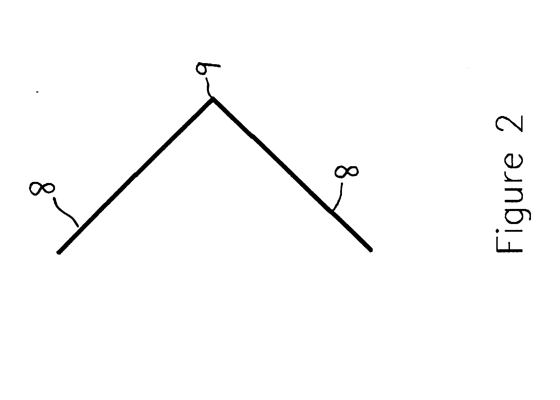

A typical form of an alignment mark for inclusion in a holographic recording layer is shown in Fig.**2**. The mark is a chevron comprising two orthogonal arms **8** of length 300µm joined at an apex **9**. The size of the chevron is such that a mechanical prealignment of the wafer with respect to the hologram produces an approximate overlapping of the hologram and wafer marks. Such a shape of mark and corresponding mark on the wafer surface can be readily interpreted by an imaging alignment system to provide measurement of the relative positions of the marks. The width of the chevron arms **8** will be discussed later.

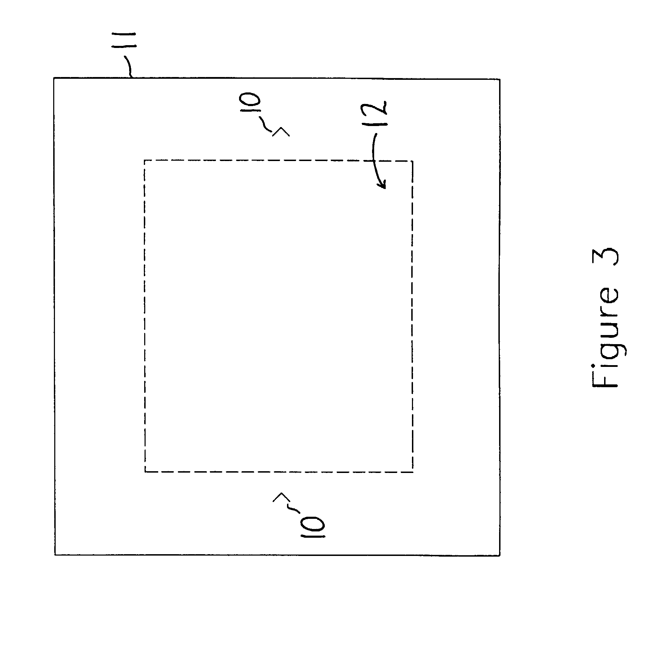

Two such alignment marks **10** are introduced (see Fig.**3**) into a photomask **11** at opposite sides of a circuit pattern **12**. The alignment marks **10** and circuit pattern **12** in the photomask **11** constitute a clear spaces in a layer of chrome on a fused silica substrate. It may be manufactured using electron-beam lithography and procured from a commercial mask shop. Two alignment marks are employed in order that angular as well as translational alignment can be accurately obtained.

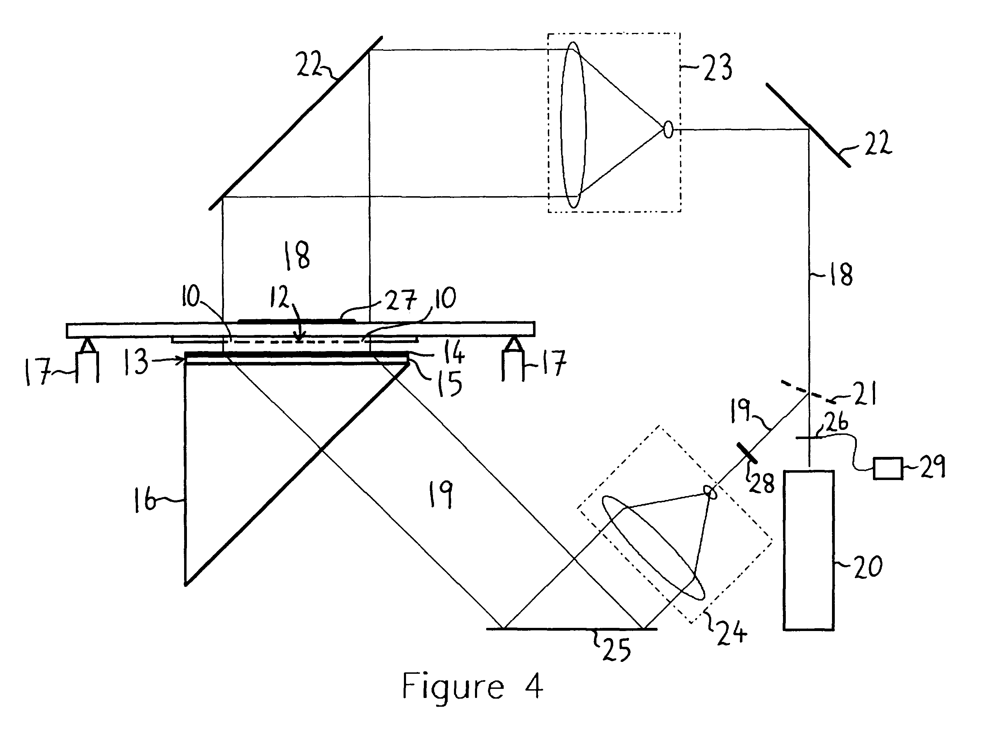

Referring now to Fig.**4**, a holographic plate **13**, comprising a 15µm layer **14** of a holographic recording material spun onto a glass substrate **15**, is index-matched to a surface of a 45°, 45°, 90° prism **16** in a TIR hologram recording system. A suitable holographic recording material would be that identified as HRS-352 and manufactured by the company Dupont de Nemours. This material contains a monomer that polymerises on exposure to light and does not require a wet development process.

The mask **11** is introduced into the system and positioned using piezo-electric transducers **17** so that it lies parallel to the recording layer **14** with a gap of 100µm between it and the layer surface. Gap measurement is best achieved interferometrically by illuminating the gap with laser beams introduced via the vertical face of the prism **16** and analysing the interference of the light reflected from the surfaces of the holographic layer **14** and mask **11**. The technique described in EP-A-02421645 is particularly suitable. The laser beams need to be of a wavelength at which the holographic recording material is not sensitive. The apparatus for doing this is not shown in Fig.**3** since it is not intrinsic to the invention and could be readily formulated by someone knowledgeable in the art. The 100µm gap and parallelism could alternatively be achieved by resting the mask **11** on 100µm thick spacers laid on the surface of the recording layer **14**.

The hologram-forming beams **18** and **19** are derived from an argon ion laser **20** operating at a wavelength of 363.8nm. The output of the laser **20** is divided by a beam splitter **21** into an object beam **18** and a reference beam **19**. The object beam **18** is reflected from a couple of mirrors **22** and passes through a beam expander **23** to illuminate the mask **11** at normal incidence. The reference beam **19** passes through another beam expander **24**, is reflected by a mirror **25** and enters the hypotenuse face of the prism **16** to illuminate the holographic recording layer **14** at 45°, an angle at which the beam **19** is totally internally reflected from the layer surface.
The alignment marks **10** in the mask **11** are transferred to the holographic layer **14** as follows. First, with the shutter **26** closed, the circuit pattern **12** in the mask **11** is covered by an opaque plate **27** and a beamblock **28** is introduced into the optical path of the reference beam **19**. The shutter **26** is then opened, thereby exposing the marks **10** in the mask **11** to the object beam **18**. In this process the light transmitted by the alignment marks **10** polymerises the recording layer **14**, changing its refractive index and causing a localised shrinkage of the layer **14**. In order that diffraction of the light transmitted by the marks **10** does not unacceptably degrade the definition of the recorded marks, the arms **8** of the chevron features must be sufficiently wide. For an exposure wavelength of 363.8nm and a gap of 100µm between the mask **11** and the recording layer **14**, a suitable width for the arms **8** would be 6µm. After sufficient exposure for forming high-contrast marks, the timing mechanism **29** closes the shutter **26**.

It is not essential that the beam **18** performing mark transfer be derived from the same laser **20** as used for hologram formation. It may instead be derived from, for instance, a mercury lamp. In this case an additional set of optics would be required in the recording system to direct the light from the second source onto the marks **10** in the mask **11**.
Following recording of the alignment marks, recording of the TIR hologram proceeds. First the opaque plate **27** and the beamblock **28** are removed from the system. To prevent contamination of the recorded alignment marks by the TIR exposure the recorded marks may be shielded from the TIR exposure by appropriately blocking parts of the object and reference beams **18 and 19** (this precaution is not essential). The shutter **26** is then opened so that the object beam **18** illuminates the mask **11** and the reference beam **19** illuminates the holographic layer **14**, forming a TIR hologram in the normal way.

An equally valid procedure would be to reverse the exposure sequence, that is, to record the TIR hologram before transferring the alignment marks **10**. In this case, however, for the TIR hologram recording, those parts of the recording layer **14** to receive the alignment marks should be shielded from the illuminating beams **18 and 19**, otherwise the TIR hologram exposure will deplete the photosensitive material in those parts of the layer **14** preventing formation of high-contrast alignment marks.

A further possible procedure is to record the alignment marks simultaneously with the TIR hologram. In this case those part of the recording layer **14** to receive the alignment marks have to be shielded from the reference beam **19** in order for the recorded alignment marks to have reasonable contrast.

Following recording of the TIR hologram and alignment marks, the recording layer **14** is then fixed by exposing it to incoherent ultraviolet radiation. The holographic plate **13** is then ready to be employed in a TIR holographic lithographic system.

### References

1. R.Dändliker, J.Brook, "Holographic Photolithography for Submicron VLSI Structures", IEEE Conf. Proc.Holographic Systems, Components and Applications, Bath, U.K., p.311 (1989).
2. S.Gray, M.Hamidi, "Holographic Microlithography for Flat Panel Displays", SID 91 Digest pp.854-857 (1991).

## Claims

1. A method for forming alignment marks (10) detectable by an alignment system and a total internal reflection hologram in a holographic recording layer for a lithographic process, which method includes:
a) providing alignment marks (10) in a mask (11), said mask defining also the pattern (12) to be reconstructed from said total internal reflection hologram;
b) providing a total internal reflection hologram recording system;
c) locating said holographic recording layer (14) and said mask (11) in the total internal reflection hologram recording system;
d) forming a total internal reflection hologram of the pattern in the mask by illuminating the mask with a first object beam (18) and the holographic recording layer (14) with a reference beam (19); and
e) transferring the alignment marks (10) in the mask (11) to the holographic recording layer (14)
**characterized in that**
the marks (10) are transferred to the holographic recording layer (14) by illuminating the mask (11) with the first object beam (18) or with a second object beam derived from a second light source;
wherein the features of the alignment marks (10) in the mask (11) are of sufficient size with regard to the wavelength of the illuminating object beam (18) and the separation of the mask (11) and recording layer (14) that the alignment marks (10) formed in the holographic recording layer (14) are well-defined regions of constant but different refractive index and/or substantially constant but different layer thickness of exposed and unexposed regions so that light reflected and scattered from either side of a boundary will combine to produce a detectable feature.

2. A method according to claim 1 wherein step e) precedes step d)

3. A method according to claim 1 wherein step e) procedes simultaneously with step d).

4. A method according to claim 1 wherein the first or second object beam that transfers the alignment marks (10) in the mask (11) into the holographic layer (14) illuminates the mask (11) at an accurately determined angle, preferably normal incidence, in order that the alignment marks (10) formed in the holographic recording layer (14) are accurately registered with respect to the pattern (12) to be reconstructed from the total internal reflection hologram.

5. A method according to any of the preceding claims 1 to 4 wherein two alignment marks (10) are introduced into the mask (11) at opposite sides of a circuit pattern (12).

6. A method according to claim 5 wherein each alignment mark (10) is a chevron comprising two orthogonal arms (8).

7. Use of alignment marks (10) formed according to any of claims 1 to 6 for measuring the relative positions of the marks (10) in a hologram (11) and corresponding marks on a wafer surface by an alignment system.

## Patentansprüche

1. Verfahren zur Herstellung von durch ein Ausrichtesystem detektierbaren Einstellmarken und eines in einer holographischen Aufnahmeschicht (14) für einen lithographischen Prozess mittels totaler interner Reflexion hergestellten Hologramms, welches Verfahren folgende Schritte einschliesst:
a)Vorsehen von Einstellmarken (10) in einer Maske (11), wobei die Maske auch das Muster (12) definiert, welches von dem mittels totaler interner Reflexion hergestellten Hologramm rekonstruiert werden soll;
b)Vorsehen eines auf totaler interner Reflexion basierenden holographischen Aufnahmesystems;
c)Plazieren der holographischen Aufnahmeschicht (14) und der Maske (11) in dem mit totaler interner Reflexion arbeitenden holographischen Aufnahmesystem;
d)Herstellung eines Hologramms des Maskenmusters mittels totaler interner Reflexion durch Belichtung der Maske mit einem ersten Objektstrahl (18) und der holographischen Aufnahmeschicht (14) mit einem Referenzstrahl (19); und
e)Uebertragen der Einstellmarken (10) der Maske (11) in die holographische Aufnahmeschicht (14), dadurch gekennzeichnet, dass die Marken (10) durch Belichten der Maske mit dem ersten Objektstrahl (18) oder mit einem zweiten Objektstrahl, welcher von einer zweiten Lichtquelle stammt, auf die holographische Aufnahmeschicht (14) übertragen werden, wobei die Strukturen der Einstellmarken (10) in der Maske (11) bezüglich der Wellenlänge des Belichtungs-Objektstrahls (18) und des Abstandes zwischen der Maske (11) und der Aufnahmeschicht (14) von ausreichender Grösse sind, sodass die Einstellmarken (10), welche in der Aufnahmeschicht (14) gebildet werden, gut definierte Bereiche sind mit einem konstanten aber unterschiedlichen Brechungsindex und/oder mit im wesentlichen konstanter aber unterschiedlicher Schichtdicke von belichteten und unbelichteten Bereichen, sodass Licht, welches von beiden Seiten einer Grenze reflektiert und gestreut wird, überlagert und ein dedektierbares Merkmal bildet.

2. Ein Verfahren gemäss Anspruch 1, dadurch gekennzeichnet, dass der Schritt e) dem Schritt d) vorangeht.

3. Ein Verfahren gemäss Anspruch 1, dadurch gekennzeichnet, dass Schritt e) gleichzeitig mit Schritt d) abläuft.

4. Verfahren gemäss Anspruch 1, dadurch gekennzeichnet, dass der erste oder zweite Objektstrahl, welcher die Einstellmarken (10) in der Maske (11) in die holographische Schicht (14) transferiert, die Maske (11) in einem genau bestimmten Winkel anstrahlt, vorzugsweise unter einem rechtwinkligen Einfallswinkel, damit die Einstellmarken (10), welche in der holographischen Aufnahmeschicht (14) gebildet werden, bezüglich des von dem mittels totaler interner Reflexion hergestellten Hologramms zu rekonstruierenden Musters (12) lage-genau sind.

5. Ein Verfahren gemäss einem der Ansprüche 1 bis 4, dadurch gekennzeichnet, dass zwei Einstellmarken (10) in der Maske (11) an gegenüberliegenden Seiten eines Schaltungsmusters (12) angebracht sind.

6. Ein Verfahren gemäss Anspruch 5, dadurch gekennzeichnet, dass jede Einstellmarke (10) eine Zickzackleiste (Chevron) mit zwei orthogonalen Armen (8) ist.

7. Verwendung von Einstellmarken (10), welche nach einem der Ansprüche 1 bis 6 hergestellt sind, zum Messen der relativen Positionen der Marken (10) in einem Hologramm (11) und korrespondierenden Marken auf einer Wafer Oberfläche durch ein Ausrichtesystem.

## Revendications

1. Procédé de formation de marques d'alignement (10) détectables par un système d'alignement et d'un hologramme à réflexion inteme totale dans une couche d'enregistrement holographique pour un procédé lithographique, lequel procédé comprend les étapes qui consistent à :
a) réaliser des marques d'alignement (10) dans un masque (11), ledit masque définissant également le motif (12) à reconstruire à partir dudit hologramme à réflexion interne totale ;
b) se procurer un système d'enregistrement d'hologramme à réflexion interne totale ;
c) positionner ladite couche d'enregistrement holographique (14) et ledit masque (11) dans le système d'enregistrement à réflexion inteme totale ;
d) former un hologramme à réflexion inteme totale du motif dans le masque grâce au fait d'illuminer le masque avec un faisceau objet (18) et la couche d'enregistrement holographique (14) avec un faisceau de référence (19) ; et
e) transférer les marques d'alignement (10) du masque (11) sur la couche d'enregistrement (14)
caractérisé en ce que
les marques (10) sont transférées sur la couche d'enregistrement holographique (14) par illumination du masque (11) avec le premier faisceau objet (18) ou avec un second faisceau objet dérivé d'une seconde source de lumière ;
les traits des marques d'alignement (10) dans le masque (11) ayant une largeur suffisante par rapport à la longueur d'onde du faisceau objet d'illumination (18) et à l'écartement entre le masque (11) et la couche d'enregistrement (14) pour que les marques d'alignement (10) formées dans la couche d'enregistrement holographique (14) soient des régions bien définies ayant chacune un indice de réfraction constant mais différent des autres et/ou une épaisseur de couche constante mais différente des autres, de régions exposées et non exposées, de telle sorte que la lumière réfléchie et diffusée à partir de chacun des côtés d'une frontière se combine pour produire un trait détectable.

2. Procédé selon la revendication 1, dans lequel l'étape e) précède l'étape d).

3. Procédé selon la revendication 1, dans lequel l'étape e) se déroule simultanément à l'étape d).

4. Procédé selon la revendication 1, dans lequel le premier ou le second faisceau objet qui transfère les marques d'alignement (10) du masque (11) dans la couche holographique (14) illumine le masque (11) selon un angle précisément déterminé, de préférence selon une incidence normale, afin que les marques d'alignement (10) formées dans la couche d'enregistrement holographique (14) soient précisément enregistrées par rapport au motif (12) pour être reconstruites à partir de l'hologramme à réflexion interne totale.

5. Procédé selon l'une quelconque des revendications précédentes 1 à 4, dans lequel deux marques d'alignement (10) sont introduites dans le masque (11) au niveau de côtés opposés d'un motif de circuit (12).

6. Procédé selon la revendication 5, dans lequel chaque marque d'alignement (10) est un chevron comprenant deux branches orthogonales (8).

7. Utilisation de marques d'alignement (10) formées selon l'une quelconque des revendications 1 à 6 pour mesurer, à l'aide d'un système d'alignement, les positions relatives des marques (10) dans un hologramme (11) et de marques correspondantes sur la surface d'une plaquette.
